# EUROPÄISCHE PATENTSCHRIFT

(11) **EP 3 301 436 B1**
(45) Veröffentlichungstag und Bekanntmachung des Hinweises auf die Patenterteilung: **07.06.2023**
(21) Anmeldenummer: 17192511.8
(22) Anmeldetag: 22.09.2017
(51) Int. Cl.: G01N 27/07

(54) **LEITFÄHIGKEITSMESSGERÄT ZUR MESSUNG EINER ELEKTRISCHEN LEITFÄHIGKEIT EINES FLÜSSIGEN MEDIUMS**
CONDUCTIVITY METER FOR MEASURING AN ELECTRICAL CONDUCTIVITY OF A LIQUID MEDIUM
APPAREIL DE MESURE DE CONDUCTIVITÉ DESTINÉ À MESURER UNE CONDUCTIVITÉ ÉLECTRIQUE D'UN MILIEU LIQUIDE

(30) Priorität: 29.09.2016 DE 102016118526
(43) Veröffentlichungstag der Anmeldung: 04.04.2018
(73) Patentinhaber: Krohne Messtechnik GmbH, 47058 Duisburg (DE)
(72) Erfinder: Glasmachers, Holger, 44795 Bochum (DE); Schmits, Christoph, 44149 Dortmund (DE)
(74) Vertreter: Gesthuysen Patentanwälte

(56) Entgegenhaltungen:
- CN-A- 103 675 349
- US-A- 4 949 581
- US-A1- 2013 214 797
- US-A1- 2014 203 824
- US-A1- 2014 208 859
- US-B2- 7 313 502
- Conductivity Analyzer Guide: "Technical Information", , 16. Juli 2009 (2009-07-16), Seiten 1-48, XP055442027, Gefunden im Internet: URL:https://web-material3.yokogawa.com/TI1 2D08A01-01E_015.pdf [gefunden am 2018-01-18]
- M Dias Pereira ET AL: "Smart oil and conductivity sensor for water quality monitoring", IMEKO 2015, vol. 79000, 4 September 2015 (2015-09-04), pages 351-265, XP055679009,

## Beschreibung

Die Erfindung betrifft ein Leitfähigkeitsmessgerät zur Messung einer elektrischen Leitfähigkeit eines flüssigen Mediums. Das Leitfähigkeitsmessgerät weist ein Gehäuse, eine konduktive erste Messzelle und eine Steuerungseinrichtung zur Steuerung der ersten Messzelle auf. Die erste Messzelle weist einen ersten Leitfähigkeitsmessbereich, eine erste Elektrode und eine zweite Elektrode auf. Dabei bilden die erste Elektrode und die zweite Elektrode die erste Messzelle.

Eine für viele Anwendungen wichtige Eigenschaft von flüssigen Medien ist deren elektrische Leitfähigkeit. Eine elektrische Leitfähigkeit eines flüssigen Mediums wird durch Ionen verursacht, wobei elektrisch positiv geladene Ionen als Kationen und elektrisch negativ geladene Ionen als Anionen bezeichnet werden. Die Messung einer elektrischen Leitfähigkeit eines flüssigen Mediums erfolgt zum Beispiel mit einer konduktiven Messzelle in Verbindung mit einer Steuerungseinrichtung. Die konduktive Messzelle weist dazu eine erste und eine zweite Elektrode auf, die beabstandet zueinander und in das flüssige Medium eingetaucht sind. Die Steuerungseinrichtung bestimmt zunächst den elektrischen Leitwert des flüssigen Mediums zwischen der ersten und zweiten Elektrode. Dabei ist der elektrische Leitwert proportional zur Fläche der ersten und zweiten Elektrode und umgekehrt proportional zum Abstand zwischen der ersten und der zweiten Elektrode. Der Quotient aus Abstand und Fläche wird auch als Zellkonstante der konduktiven Messzelle bezeichnet. Die Steuerungseinrichtung bestimmt den Leitwert, indem die Steuerungseinrichtung z. B. eine Spannung zwischen den Elektroden anlegt und den durch die Spannung fließenden Strom bestimmt. Der Leitwert ist der Quotient aus dem gemessenen Strom und der anliegenden Spannung. Dann bestimmt die Steuerungseinrichtung die Leitfähigkeit des flüssigen Mediums, indem die Steuerungseinrichtung den Leitwert mit der Zellkonstante multipliziert.

Eine elektrische Spannung, wie z. B. die Spannung zur Bestimmung des Leitwerts, zwischen der ersten und der zweiten Elektrode lädt die erste Elektrode negativ und die zweite Elektrode positiv auf, wodurch im flüssigen Medium zwischen der ersten und der zweiten Elektrode ein elektrisches Feld entsteht. Das elektrische Feld bewirkt eine Bewegung der Kationen zur negativ geladenen Elektrode und eine Bewegung der Anionen zur positiv geladenen Elektrode. Die Kationen an der negativ geladenen Elektrode und die Anionen an der positiv geladenen Elektrode bewirken eine Polarisationskapazität, welche das elektrische Feld im Medium und damit auch die Bestimmung des Leitwerts beeinträchtigt. Durch eine geeignete Wahl der Zellkonstante, also durch eine geeignete Wahl des Abstands zwischen der ersten und der zweiten Elektrode und durch die geeignete Wahl der Fläche der ersten und der zweiten Elektrode, ist es möglich, die Beeinträchtigung der Bestimmung des Leitwerts durch die Polarisationskapazität zu reduzieren.

Aus dem Stand der Technik sind Leitfähigkeitsmessgeräte mit einer konduktiven Messzelle bekannt, die einen Dynamikumfang von etwa 100 aufweisen. Ein Dynamikumfang von 100 bedeutet, dass der Quotient aus der maximal bestimmbaren und aus der minimal bestimmbaren Leitfähigkeit 100 ist. Die maximal bestimmbare Leitfähigkeit und die minimal bestimmbare Leitfähigkeit sind dadurch gekennzeichnet, dass sie die maximal für eine Anwendung zulässige Messtoleranz von der tatsächlichen Leitfähigkeit eines Mediums aufweisen. Werden mit einer Messzelle Leitfähigkeiten gemessen, die entweder größer als die maximal bestimmbare Leitfähigkeit oder kleiner als die minimal bestimmbare Leitfähigkeit sind, so ist die Messtoleranz für die Anwendung nicht mehr tolerierbar. Jedoch erfordert eine Vielzahl von Anwendungen einen Dynamikumfang von weit mehr als 100.

Aus der Druckschrift US 2013/0214797 A1 ist eine Sensorvorrichtung zur Detektierung von Eigenschaften eines flüssigen Mediums in einem Container bekannt. Dazu weist die Sensorvorrichtung zumindest eine Grundplatte und zumindest zwei Sensorelemente auf. Die Grundplatte ist aus einem isolierenden Material gemacht und hat eine erste Oberfläche, welche dem Medium ausgesetzt ist. Die zumindest zwei Sensorelemente haben eine erste und eine zweite Elektrode, welche isoliert voneinander auf der ersten Oberfläche der Grundplatte angeordnet sind und um welche das Medium strömt. Die zumindest zwei Sensorelemente sind in einer vorbestimmten räumlichen Position relativ zueinander angeordnet.

Die Druckschrift US 2014/0208859 A1 offenbart ein Membran-Gasdruckmessgerät. Das Messgerät weist einen ersten Sensor zur Messung eines Gasdrucks in einem ersten Messbereich und einen zweiten Sensor zur Messung eines Gasdrucks in einem zweiten Messbereich auf. Dabei sind der erste und der zweite Sensor derart ausgebildet, dass sich der erste Messbereich und der zweite Messbereich überlappen und der übrige Messbereich des zweiten Sensors oberhalb und der übrige Messbereich des ersten Sensors unterhalb des sich überlappenden Messbereichs befinden. Weiter weist das Messgerät eine Steuerungseinrichtung auf.

Die Druckschrift US 7,313,502 B2 beschreibt ein industrielles Automatisierungssystem, welches Daten aggregiert. Das System umfasst eine Mehrzahl an Sensoren, eine Gewichtungskomponente und eine Kombinationskomponente. Die Sensoren stellen redundante detektierte Daten zur Verfügung, wobei die Redundanz z. B. durch Überlappung von Messbereichen erzeugt wird. Die Gewichtungskomponente gewichtet die detektierten Daten basierend auf einem Vertrauen in die Genauigkeit der Messsungen der Daten durch die Sensoren. Die Kombinationskomponente kombiniert die detektierten redundanten Daten und Gewichte der Daten, sodass harmonisierte Daten entstehen.

Der Erfindung liegt die Aufgabe zugrunde, eine Zuverlässigkeit des Leitfähigkeitsmessgeräts zu verbessern.

Die hergeleitete und aufgezeigte Aufgabe ist zunächst im Wesentlichen dadurch gelöst, dass das Leitfähigkeitsmessgerät eine zweite Messzelle mit einem zweiten Leitfähigkeitsmessbereich aufweist, dass die erste und zweite Messzelle und die Steuerungseinrichtung am Gehäuse angeordnet sind und dass die Steuerungseinrichtung zur Steuerung der zweiten Messzelle ausgebildet ist. Das erfindungsgemäße Leitfähigkeitsmessgerät weist demnach neben der ersten Messzelle mit dem ersten Leitfähigkeitsmessbereich auch mindestens eine weitere Messzelle, nämlich die zweite Messzelle mit dem zweiten Leitfähigkeitsmessbereich, auf, wobei die Steuerungseinrichtung zur Steuerung aller Messzellen ausgebildet ist.

Der Leitfähigkeitsmessbereich des Leitfähigkeitsmessgeräts ist durch den ersten Leitfähigkeitsmessbereich und den zweiten Leitfähigkeitsmessbereich bestimmt. Weiter ist erfindungsgemäß vorgesehen, dass die erste Messzelle und die zweite Messzelle derart ausgebildet sind, dass sich der erste Leitfähigkeitsmessbereich und der zweite Leitfähigkeitsmessbereich überlappen, sodass das Leitfähigkeitsmessgerät einen zusammenhängenden Leitfähigkeitsmessbereich aufweist. Der Leitfähigkeitsmessbereich, in dem sich der erste Leitfähigkeitsmessbereich und der zweite Leitfähigkeitsmessbereich überlappen, wird auch als Überlappungsleitfähigkeitsmessbereich bezeichnet. Eine elektrische Leitfähigkeit eines flüssigen Mediums, die im Überlappungsleitfähigkeitsmessbereich liegt, kann durch die Steuerungseinrichtung sowohl mit der ersten Messzelle als auch mit der zweiten Messzelle bestimmt werden, wodurch die Bestimmung der elektrischen Leitfähigkeit des flüssigen Mediums eine Redundanz aufweist.

Weiter ist erfindungsgemäß vorgesehen, dass die Steuerungseinrichtung ausgebildet ist, zunächst eine erste Leitfähigkeit des Mediums mit der ersten Messzelle und eine zweite Leitfähigkeit des Mediums mit der zweiten Messzelle zu bestimmen. Weiter ist die Steuerungseinrichtung ausgebildet, dann einen Fehler zu signalisieren, wenn die bestimmte erste Leitfähigkeit und/oder die bestimmte zweite Leitfähigkeit in dem Überlappungsleitfähigkeitsmessbereich liegen und die bestimmte erste Leitfähigkeit von der bestimmten zweiten Leitfähigkeit um mehr als einen Leitfähigkeitstoleranzwert voneinander abweichen. Dabei ist der Leitfähigkeitstoleranzwert der Steuerungseinrichtung vorgegeben, wobei dieser von der jeweiligen Anwendung abhängig ist. Dieser Weiterbildung liegt die Erkenntnis zugrunde, dass bei einem flüssigen Medium, dessen elektrische Leitfähigkeit im Überlappungsleitfähigkeitsmessbereich liegt, sowohl die erste Messzelle als auch die zweite Messzelle im Rahmen ihrer jeweiligen Messtoleranz die gleiche elektrische Leitfähigkeit liefern müssten, wenn kein Fehler vorliegt. Die Messtoleranz der ersten und die Messtoleranz der zweiten Messzelle sind bei der Wahl des Leitfähigkeitstoleranzwerts zu berücksichtigen. Insbesondere ist der Leitfähigkeitstoleranzwert größer zu wählen als die größere der beiden Messtoleranzen.

In einer Ausgestaltung des Leitfähigkeitsmessgeräts ist vorgesehen, dass die Steuerungseinrichtung ausgebildet ist, durch die Redundanz aufgrund des Überlappungsleitfähigkeitsmessbereichs die Zuverlässigkeit von Sicherheitsfunktionen zu verbessern, wodurch das Sicherheits-Integritäts-Level (SIL) erhöht wird.

Als Messzellen für das Leitfähigkeitsmessgerät kommen grundsätzlich zum einen konduktive Messzellen und zum anderen induktive Messzellen infrage. In einer weiteren Ausgestaltung des Leitfähigkeitsmessbereichs ist vorgesehen, dass die zweite Messzelle eine konduktive Messzelle ist. Somit sind sowohl die erste Messzelle als auch die zweite Messzelle konduktive Messzellen, wodurch die Anpassung der Steuerungseinrichtung an die zweite Messzelle, sodass die Steuerungseinrichtung sowohl die erste als aus die zweite Messzelle steuert, einfacher ist, als wenn die zweite Messzelle eine induktive Messzelle wäre. Auf diese Weise werden Herstellungskosten eingespart.

In einer Weiterbildung der vorangehenden Ausgestaltung ist zur weiteren Kosteneinsparung vorgesehen, dass das Leitfähigkeitsmessgerät eine dritte Elektrode aufweist und dass die zweite Elektrode und die dritte Elektrode die zweite Messzelle bilden. Die die erste und die zweite Messzelle weisen somit insgesamt drei Elektroden auf.

In einer Weiterbildung der vorangehenden Weiterbildung ist zur Vergrößerung des Leitfähigkeitsmessbereichs des Leitfähigkeitsmessgeräts und/oder zur Erhöhung der Redundanz durch eine Vergrößerung des Überlappungsleitfähigkeitsmessbereichs vorgesehen, dass die erste Elektrode und die dritte Elektrode eine konduktive dritte Messzelle mit einem dritten Leitfähigkeitsmessbereich bilden und dass die Steuerungseinrichtung zur Steuerung auch der dritten Messzelle ausgebildet ist. Somit steuert die Steuerungseinrichtung nicht nur die erste und die zweite Messzelle, sondern auch die dritte Messzelle. Da alle Messzellen konduktive Messzellen sind, ist die Anapassung der Steuerungseinrichtung einfacher, als wenn wenigstens eine der Messzellen eine induktive Messzelle wäre.

Die räumliche Ausbildung und Anordnung der Messzellen und damit der Elektroden kann auf verschiedene Weisen erfolgen. In einer Ausgestaltung der Ausbildung und Anordnung der Elektroden ist vorgesehen, dass mindestens die erste Elektrode und die zweite Elektrode zylinderförmig ausgebildet und koaxial ineinander angeordnet sind. In einer anderen Ausgestaltung ist vorgesehen, dass mindestens die erste Elektrode und die zweite Elektrode plattenförmig ausgebildet und parallel zueinander angeordnet sind. In einer anderen Ausgestaltung ist vorgesehen, dass das Leitfähigkeitsmessgerät eine Trägerplatte aufweist und dass mindestens die erste Elektrode und die zweite Elektrode auf der Trägerplatte nebeneinander angeordnet sind.

In einer weiteren Ausgestaltung des Leitfähigkeitsmessgeräts ist vorgesehen, dass die zweite Messzelle keine konduktive Messzelle, sondern eine induktive Messzelle ist. Eine induktive Messzelle weist für gewöhnlich eine Sendespule und eine Empfangsspule auf. Zur Messung einer elektrischen Leitfähigkeit eines elektrisch leitfähigen flüssigen Mediums wird die induktive Messzelle in das Medium eingetaucht, wodurch die Sendespule und die Empfangsspule miteinander induktiv gekoppelt sind. Die Steuerungseinrichtung ist ausgebildet, elektrische Sendesignale zu erzeugen und der Sendespule zuzuführen, über das Medium in die Empfangsspule induzierte Messsignale zu messen und aus den Messsignalen die Leitfähigkeit des Mediums zu bestimmen.

In einer Ausgestaltung des Leitfähigkeitsmessgeräts, bei dem die zweite Messzelle eine induktive Messzelle ist, ist vorgesehen, dass das Leitfähigkeitsmessgerät einen zylinderförmigen, vorzugsweise hohlzylinderförmigen, Träger aufweist und die induktive Messzelle um den zylinderförmigen Träger angeordnet ist. Weiter ist vorgesehen, dass die erste Elektrode und die zweite Elektrode der ersten Messzelle zylinderförmig ausgebildet und koaxial ineinander angeordnet sind. Darüber hinaus sind die erste Messzelle und die zweite Messzelle koaxial ineinander angeordnet. Vorzugsweise ist bei der koaxialen Anordnung der ersten Messzelle und der zweiten Messzelle, die erste Messzelle um die zweite Messzelle angeordnet. Diese Ausgestaltung ist dadurch ausgezeichnet, dass die erste Messzelle, von der zweiten Messzelle erzeugte magnetische Felder abschirmt. Wenn die induktive Messzelle eine Sendespule und/oder eine Empfangsspule aufweist, ist die induktive Messzelle dadurch um den zylinderförmigen Träger angeordnet, dass die Sendespule und/oder die Empfangsspule um den zylinderförmigen Träger angeordnet sind bzw. ist.

Bei einem Leitfähigkeitsmessgerät mit einer konduktiven ersten Messzelle und einer induktiven zweiten Messzelle kann die räumliche Anordnung der ersten und der zweiten Messzelle auf verschiedene Weisen erfolgen. In einer Ausgestaltung der Anordnung ist vorgesehen, dass die erste Messzelle neben der oder parallel zur zweiten Messzelle angeordnet ist. In einer zweiten Ausgestaltung ist vorgesehen, dass die erste Messzelle in Reihe, z. B. koaxial, vor oder hinter der zweiten Messzelle angeordnet ist. In einer weiteren Ausgestaltung ist vorgesehen, dass die erste Messzelle unter der zweiten Messzelle angeordnet ist. In einer weiteren Ausgestaltung ist vorgesehen, dass das Gehäuse des Leitfähigkeitsmessgeräts einen Halteschaft aufweist und die erste Messzelle in dem oder an dem Halteschaft angeordnet ist.

In einer weiteren Ausgestaltung des Leitfähigkeitsmessgeräts ist vorgesehen, dass die Steuerungseinrichtung einen Wechselschalter aufweist, dass der Wechselschalter von der Steuerungseinrichtung gesteuert ist und dass der Wechselschalter die Steuerungseinrichtung zumindest mit der ersten Messzelle oder der zweiten Messzelle elektrisch verbindet. Der Wechselschalter ermöglicht die Verwendung einer einzigen Steuerungseinrichtung für die mindestens erste und zweite Messzelle. Wenn der Wechselschalter die Steuerungseinrichtung mit einer der Messzellen zur Steuerung dieser Messzelle durch die Steuerungseinrichtung verbindet, so ist das eine exklusive Verbindung, was bedeutet, dass ausschließlich diese Messzelle von der Steuerungseinrichtung gesteuert wird.

Im Einzelnen ist eine Vielzahl von Möglichkeiten gegeben, das erfindungsgemäße Leitfähigkeitsmessgerät auszugestalten und weiterzubilden. Dazu wird verwiesen sowohl auf die dem unabhängigen Patentanspruch nachgeordneten Patentansprüche als auch auf die nachfolgende Beschreibung von bevorzugten Ausführungsbeispielen in Verbindung mit der Zeichnung. In der Zeichnung zeigt
- Fig. 1: ein erstes Ausführungsbeispiel eines Leitfähigkeitsmessgeräts mit einer konduktiven ersten und zweiten Messzelle in einer Anordnung,
- Fig. 2: eine Schnittdarstellung des Leitfähigkeitsmessgeräts aus Fig. 1,
- Fig. 3: ein zweites Ausführungsbeispiel eines Leitfähigkeitsmessgeräts in einer Schnittdarstellung mit einer konduktiven ersten und zweiten Messzelle in einer weiteren Anordnung,
- Fig. 4: ein drittes Ausführungsbeispiel eines Leitfähigkeitsmessgeräts in einer Schnittdarstellung mit einer konduktiven ersten und zweiten Messzelle in einer weiteren Anordnung,
- Fig. 5: ein viertes Ausführungsbeispiel eines Leitfähigkeitsmessgeräts mit einer konduktiven ersten und einer induktiven zweiten Messzelle in einer Anordnung,
- Fig. 6: eine Schnittdarstellung des Leitfähigkeitsmessgeräts aus Fig. 5,
- Fig. 7: ein fünftes Ausführungsbeispiel eines Leitfähigkeitsmessgeräts in Schnittdarstellung mit einer konduktiven ersten und einer induktiven zweiten Messzelle in einer weiteren Anordnung,
- Fig. 8: ein sechstes Ausführungsbeispiel eines Leitfähigkeitsmessgeräts in Schnittdarstellung mit einer konduktiven ersten und einer induktiven zweiten Messzelle in einer weiteren Anordnung,
- Fig. 9: ein siebtes Ausführungsbeispiel eines Leitfähigkeitsmessgeräts in Schnittdarstellung mit einer konduktiven ersten und einer induktiven zweiten Messzelle in einer weiteren Anordnung und
- Fig. 10: ein achtes Ausführungsbeispiel eines Leitfähigkeitsmessgeräts in Schnittdarstellung mit einer konduktiven ersten und einer induktiven zweiten Messzelle in einer weiteren Anordnung.

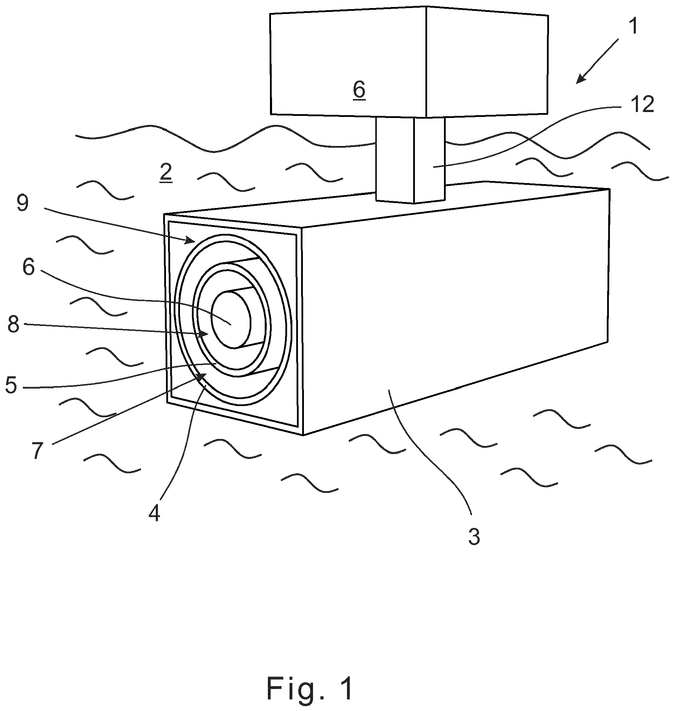

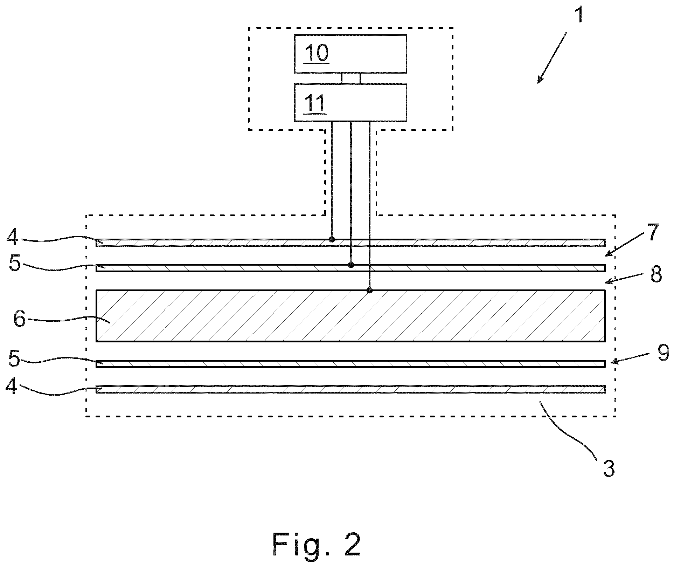

Fig. 1 zeigt ein erstes Ausführungsbeispiel eines Leitfähigkeitsmessgeräts 1 zur Messung einer elektrischen Leitfähigkeit eines flüssigen Mediums 2 in abstrahierter Darstellung. Fig. 2 zeigt das Ausführungsbeispiel in einer Schnittdarstellung. Das Leitfähigkeitsmessgerät 1 weist ein Gehäuse 3, eine erste Elektrode 4, eine zweite Elektrode 5 und eine dritte Elektrode 6 auf, wobei die Elektroden 4, 5, 6 am Gehäuse 3 angeordnet sind. Die erste Elektrode 4 und die zweite Elektrode 5 bilden eine konduktive erste Messzelle 7 mit einem ersten Leitfähigkeitsmessbereich, die zweite Elektrode 5 und die dritte Elektrode 6 bilden eine konduktive zweite Messzelle 8 mit einem zweiten Leitfähigkeitsmessbereich und die erste Elektrode 4 und die dritte Elektrode 6 bilden eine konduktive dritte Messzelle 9 mit einem dritten Leitfähigkeitsmessbereich. Das Medium 2 ist dabei insbesondere zum einen zwischen der ersten Elektrode 4 und der zweiten Elektrode 5 und zum anderen zwischen der zweiten Elektrode 5 und der dritten Elektrode 6 und in Kontakt mit den Elektroden 4, 5, 6. Durch die Anordnung der Elektroden 4, 5, 6 am Gehäuse 3 sind auch die Messzellen 7, 8, 9 am Gehäuse angeordnet. Jede der Messzellen 7, 8, 9 weist jeweils eine Zellkonstante auf, wobei die Zellkonstanten derart bestimmt sind, dass zum einen der erste Leitfähigkeitsmessbereich und der zweite Leitfähigkeitsmessbereich einander überlappen, sodass ein erster Überlappungsleitfähigkeitsmessbereich entsteht, und dass zum anderen der zweite Leitfähigkeitsmessbereich und der dritte Leitfähigkeitsmessbereich einander überlappen, sodass ein zweiter Überlappungsleitfähigkeitsmessbereich entsteht.

Darüber hinaus weist das Leitfähigkeitsmessgerät 1 eine Steuerungseinrichtung 10 mit einem Wechselschalter 11 auf, wobei die Steuerungseinrichtung 10 zur Steuerung des Wechselschalters 11 ausgebildet ist. Die Steuerungseinrichtung 10 ist darüber hinaus auch zur Steuerung der Messzellen 7, 8, 9 ausgebildet. Der Wechselschalter 11 ermöglicht die Verwendung der einzigen Steuerungseinrichtung 10 mit der Mehrzahl der Messzellen 7, 8, 9. Der Wechselschalter 11 verbindet, gesteuert durch die Steuerungseinrichtung 10, die Steuerungseinrichtung 10 entweder mit der ersten Messzelle 7 oder der zweiten Messzelle 8 oder der dritten Messzelle 9, sodass die Steuerungseinrichtung 10 im Betrieb in einem Zeitpunkt jeweils mit einer der Messzellen 7, 8, 9 eine Leitfähigkeit des flüssigen Mediums 2 bestimmt. Dabei ist die Verbindung zwischen der Steuerungseinrichtung 10 und einer der Messzellen 7, 8, 9 exklusiv, was bedeutet, dass die anderen beiden Messzellen dann nicht durch die Steuerungseinrichtung 10 steuerbar sind. Die Ausbildung der Steuerungseinrichtung 10 zur Steuerung der Messzellen 7, 8, 9 umfasst insbesondere die Ausbildung zur Bestimmung einer Leitfähigkeit eines Mediums mit den Messzellen 7, 8, 9.

Weiterhin ist die Steuerungseinrichtung 10 ausgebildet, im Betrieb zunächst eine erste Leitfähigkeit des Mediums 2 mit der ersten Messzelle 7 und eine zweite Leitfähigkeit des Mediums 2 mit der zweiten Messzelle 8 zu bestimmen und dann einen Fehler zu signalisieren, wenn die bestimmte erste Leitfähigkeit und/oder die bestimmte zweite Leitfähigkeit in dem ersten Überlappungsleitfähigkeitsmessbereich liegen bzw. liegt und die bestimmte erste Leitfähigkeit und die bestimmte zweite Leitfähigkeit um mehr als einen in der Steuerungseinrichtung 10 hinterlegten Leitfähigkeitstoleranzwert voneinander abweichen. Entsprechend ist die Steuerungseinrichtung 10 ausgebildet, zunächst eine erste Leitfähigkeit des Mediums 2 mit der zweiten Messzelle 8 und eine zweite Leitfähigkeit des Mediums 2 mit der dritten Messzelle 9 zu bestimmen und dann einen Fehler zu signalisieren, wenn die bestimmte erste Leitfähigkeit und/oder die bestimmte zweite Leitfähigkeit in dem zweiten Überlappungsleitfähigkeitsmessbereich liegen bzw. liegt und die bestimmte erste Leitfähigkeit und die bestimmte zweite Leitfähigkeit um mehr als den Leitfähigkeitstoleranzwert voneinander abweichen. Dieser Ausgestaltung der Steuerungseinrichtung 10 liegt die Erkenntnis zugrunde, dass bei einem flüssigen Medium, dessen elektrische Leitfähigkeit entweder im ersten Überlappungsleitfähigkeitsmessbereich oder im zweiten Überlappungsleitfähigkeitsmessbereich liegt, entweder die erste Messzelle 7 und die zweite Messzelle 8 oder die zweite Messzelle 8 und die dritte Messzelle 9 im Rahmen ihrer jeweiligen Messtoleranz die gleiche elektrische Leitfähigkeit des Mediums 2 liefern müssten, wenn kein Fehler vorliegt. Bei der Wahl des Leitfähigkeitstoleranzwerts sind die Messtoleranzen der Messzellen 7, 8, 9 zu berücksichtigen. Insbesondere ist der Leitfähigkeitstoleranzwert größer zu wählen als die größte der drei Messtoleranzen.

Das Gehäuse 3 des Leitfähigkeitsmessgeräts 1 weist darüber hinaus einen Halteschaft 12 auf, an dem das Leitfähigkeitsmessgerät 1 befestigt werden kann, sodass die Messzellen 7, 8, 9 in das leitfähige flüssige Medium 2 eingetaucht sind. Darüber hinaus verbindet der Halteschaft 12 den Teil des Gehäuses 3, in dem die Steuerungseinrichtung 10 und der Wechselschalter 11 angeordnet sind, mit dem Teil des Gehäuses 3, in dem die Messzellen 7, 8, 9 angeordnet sind. Im Halteschaft 12 verlaufen für gewöhnlich auch elektrischen Verbindungsleitungen, welche die Elektroden 4, 5, 6 mit dem Wechselschalter 11 verbinden.

In diesem Ausführungsbeispiel sind die Elektroden 4, 5, 6 zylinderförmig ausgebildet. Dabei sind die erste Elektrode 4 und die zweite Elektrode 5 jeweils ein Hohlzylinder und ist die dritte Elektrode 6 ein Vollzylinder aus einem elektrisch leitfähigen Material. Die Elektroden 4, 5, 6 sind koaxial ineinander angeordnet.

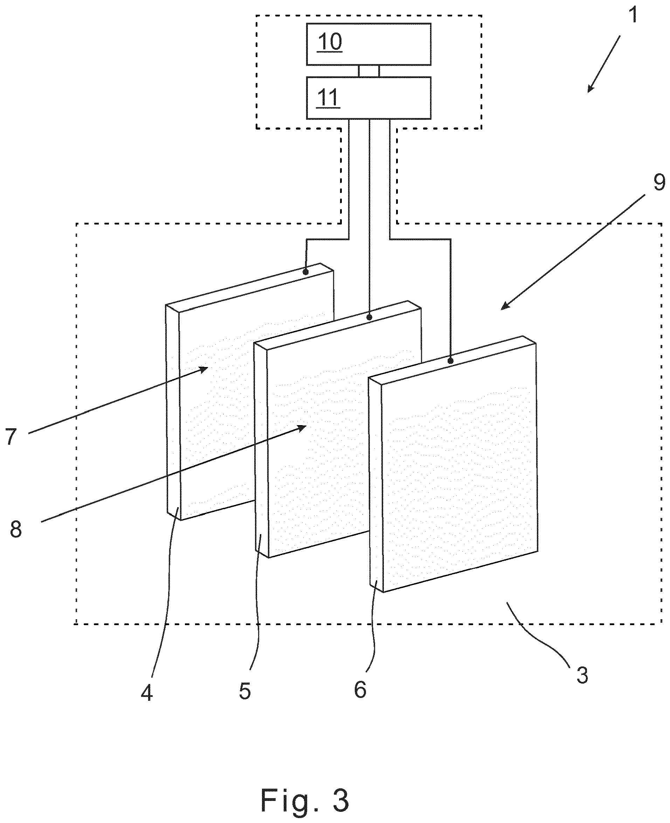

Fig. 3 zeigt ein zweites Ausführungsbeispiel eines Leitfähigkeitsmessgeräts 1 in einer abstrahierten Schnittdarstellung. Dieses Ausführungsbeispiel entspricht dem ersten Ausführungsbeispiel abgesehen von den im Folgenden dargestellten Unterschieden, weshalb im Übrigen die Ausführungen zum ersten Ausführungsbeispiel entsprechend für das zweite Ausführungsbeispiel gelten.

Das zweite Ausführungsbeispiel des Leitfähigkeitsmessgeräts 1 weist wie das erste Ausführungsbeispiel eine erste Elektrode 4, eine zweite Elektrode 5 und eine dritte Elektrode 6 auf, wobei die Elektroden nicht zylinderförmig, sondern plattenförmig ausgebildet sind. Die Elektroden sind auch nicht koaxial ineinander, sondern parallel zueinander angeordnet.

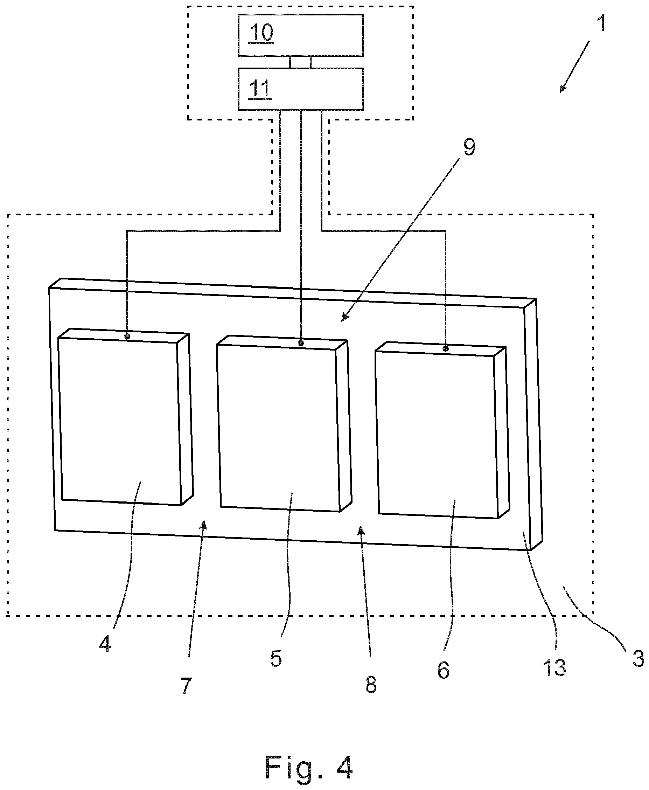

Fig. 4 zeigt ein drittes Ausführungsbeispiel eines Leitfähigkeitsmessgeräts 1 in einer abstrahierten Schnittdarstellung. Dieses Ausführungsbeispiel entspricht dem ersten Ausführungsbeispiel abgesehen von den im Folgenden dargestellten Unterschieden, weshalb im Übrigen die Ausführungen zum ersten Ausführungsbeispiel entsprechend für das dritte Ausführungsbeispiel gelten.

Das dritte Ausführungsbeispiel des Leitfähigkeitsmessgeräts 1 weist wie das erste Ausführungsbeispiel eine erste Elektrode 4, eine zweite Elektrode 5 und eine dritte Elektrode 6 auf. Darüber hinaus weist das Leitfähigkeitsmessgerät 1 eine Trägerplatte 13 auf, auf welcher die erste Elektrode 4, die zweite Elektrode 5 und die dritte Elektrode 6 nebeneinander angeordnet sind.

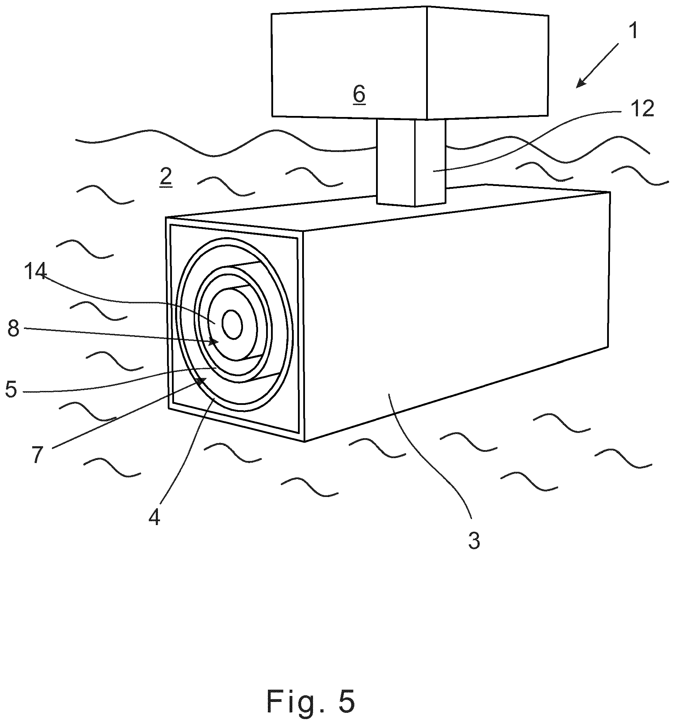

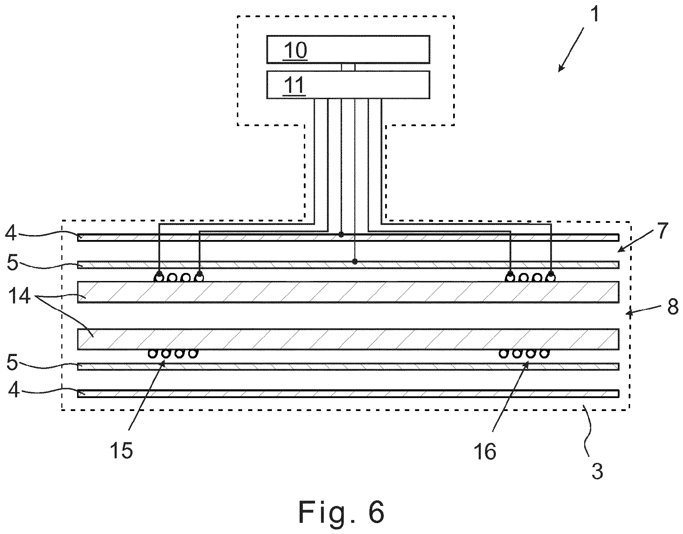

Fig. 5 zeigt ein viertes Ausführungsbeispiel eines Leitfähigkeitsmessgeräts 1 zur Messung einer elektrischen Leitfähigkeit eines flüssigen Mediums 2 mit einem Gehäuse 3, einer konduktiven ersten Messzelle 7 und einer induktiven zweiten Messzelle 8 in abstrahierter Darstellung. Fig. 6 zeigt das Ausführungsbeispiel in einer Schnittdarstellung. Im Gegensatz zu den vorangehenden Ausführungsbeispielen weist das Leitfähigkeitsmessgerät 1 gemäß diesem Ausführungsbeispiel nun nicht mehr nur konduktive Messzellen, sondem auch die induktive zweite Messzelle 8 auf.

Die erste Messzelle 7 weist einen ersten Leitfähigkeitsmessbereich auf und wird durch die erste Elektrode 4 und die zweite Elektrode 5 gebildet, wobei die beiden Elektroden 4, 5 zylinderförmig ausgebildet und am Gehäuse 3 angeordnet sind, wodurch auch die erste Messzelle 7 am Gehäuse 3 angeordnet ist. Die zweite Messzelle 8 weist einen zweiten Leitfähigkeitsmessbereich und einen hohlzylinderförmigen Träger 14 auf, welcher ebenfalls am Gehäuse 3 angeordnet ist und auf welchem eine Sendespule 15 und eine Empfangsspule 16 aufgewickelt sind. Der zylinderförmige Träger 14, die erste Elektrode 4 und die zweite Elektrode 5 sind koaxial ineinander angeordnet. Das Medium 2 ist dabei insbesondere zwischen der ersten Elektrode 4 und der zweiten Elektrode 5 und mit den Elektroden 4, 5 in Kontakt. Weiterhin ist das Medium 2 auch im hohlzylinderförmigen Träger 14. Die erste Messzelle 7 und die zweite Messzelle 8 sind derart ausgebildet, dass der erste Leitfähigkeitsmessbereich und der zweite Leitfähigkeitsmessbereich einander überlappen, so dass ein erster Überlappungsleitfähigkeitsbereich entsteht.

Darüber hinaus weist das Leitfähigkeitsmessgerät 1 eine Steuerungseinrichtung 10 mit einem Wechselschalter 11 auf, wobei die Steuerungseinrichtung 10 zur Steuerung des Wechselschalters 11 ausgebildet ist. Die Steuerungseinrichtung 10 ist darüber hinaus auch zur Steuerung der Messzellen 7, 8 ausgebildet. Der Wechselschalter 11 ermöglicht die Verwendung der einzigen Steuerungseinrichtung 10 mit der Mehrzahl der Messzellen 7, 8. Der Wechselschalter 11 verbindet, gesteuert durch die Steuerungseinrichtung 10, die Steuerungseinrichtung 10 entweder mit der ersten Messzelle 7 oder der zweiten Messzelle 8, sodass die Steuerungseinrichtung 10 im Betrieb in einem Zeitpunkt jeweils mit einer der Messzellen 7, 8 eine Leitfähigkeit des flüssigen Mediums 2 bestimmt. Dabei ist die Verbindung zwischen der Steuerungseinrichtung 10 und einer der Messzellen 7, 8 exklusiv, was bedeutet, dass die andere Messzelle dann nicht durch die Steuerungseinrichtung 10 steuerbar ist. Die Ausbildung der Steuerungseinrichtung 10 zur Steuerung der Messzellen 7, 8 umfasst insbesondere die Ausbildung zur Bestimmung einer Leitfähigkeit eines Mediums mit den Messzellen 7, 8.

Im Übrigen gelten die Ausführungen für das erste Ausführungsbeispiel entsprechend auch für das vierte Ausführungsbeispiel.

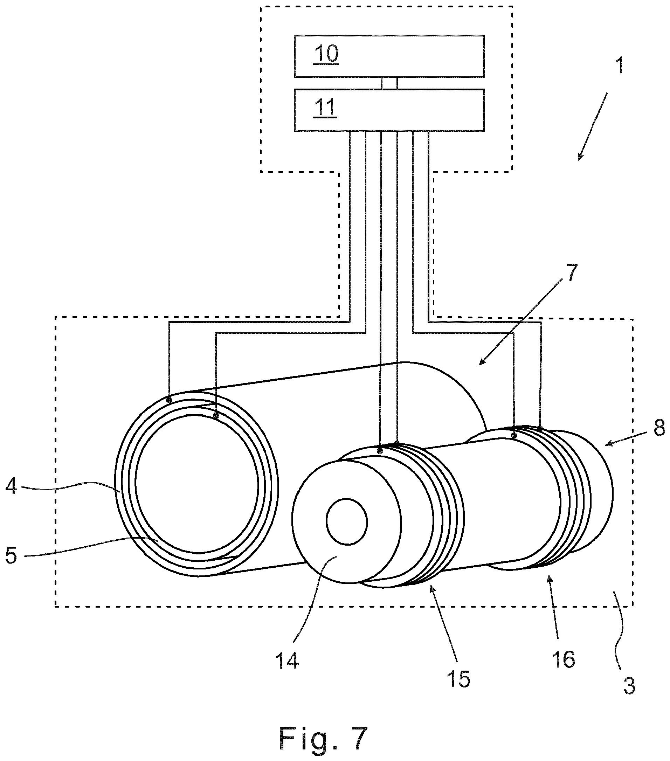

Fig. 7 zeigt ein fünftes Ausführungsbeispiel eines Leitfähigkeitsmessgeräts 1 in einer abstrahierten Schnittdarstellung. Dieses Ausführungsbeispiel entspricht dem vierten Ausführungsbeispiel abgesehen von den im Folgenden dargestellten Unterschieden, weshalb im Übrigen die Ausführungen zum vierten Ausführungsbeispiel entsprechend für das fünfte Ausführungsbeispiel gelten.

Das fünfte Ausführungsbeispiel des Leitfähigkeitsmessgeräts 1 weist wie das vierte Ausführungsbeispiel eine konduktive erste Messzelle 7 und eine induktive zweite Messzelle 8 auf. Die Messzellen 7, 8 sind jedoch nicht koaxial ineinander, sondern parallel zueinander in einer Ebene senkrecht zum Halteschaft 12 angeordnet. Dabei ist die Anordnung parallel zueinander eine Sonderform einer Anordnung nebeneinander.

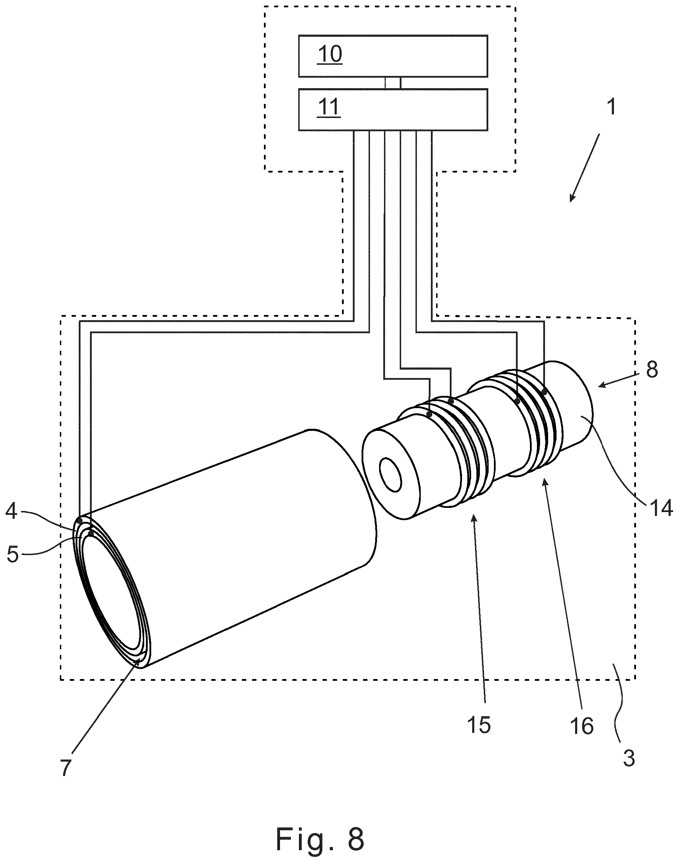

Fig. 8 zeigt ein sechstes Ausführungsbeispiel eines Leitfähigkeitsmessgeräts 1 in einer abstrahierten Schnittdarstellung. Dieses Ausführungsbeispiel entspricht dem vierten Ausführungsbeispiel abgesehen von den im Folgenden dargestellten Unterschieden, weshalb im Übrigen die Ausführungen zum vierten Ausführungsbeispiel entsprechend für das sechste Ausführungsbeispiel gelten.

Das sechste Ausführungsbeispiel des Leitfähigkeitsmessgeräts 1 weist wie das vierte Ausführungsbeispiel eine konduktive erste Messzelle 7 und eine induktive zweite Messzelle 8 auf. Die Messzellen 7, 8 sind jedoch nicht koaxial ineinander, sondern koaxial in Reihe hintereinander angeordnet. In diesem Ausführungsbeispiel ist die erste Messzelle 7 vor der zweiten Messzelle 8 angeordnet, wobei in anderen Ausführungsbeispielen auch eine umgekehrte Anordnung gegeben ist.

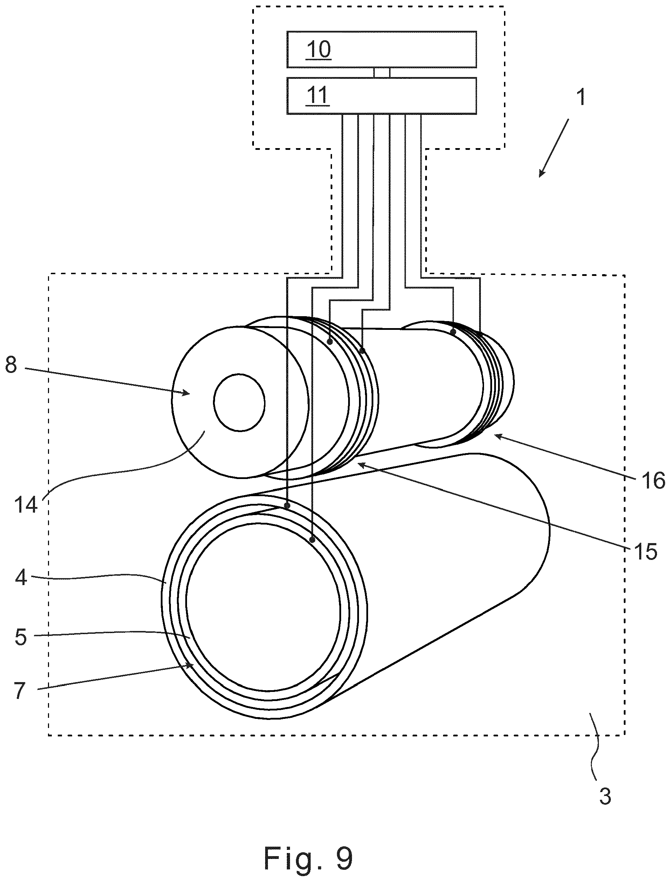

Fig. 9 zeigt ein siebtes Ausführungsbeispiel eines Leitfähigkeitsmessgeräts 1 in einer abstrahierten Schnittdarstellung. Dieses Ausführungsbeispiel entspricht dem vierten Ausführungsbeispiel abgesehen von den im Folgenden dargestellten Unterschieden, weshalb im Übrigen die Ausführungen zum vierten Ausführungsbeispiel entsprechend für das siebte Ausführungsbeispiel gelten.

Das siebte Ausführungsbeispiel des Leitfähigkeitsmessgeräts 1 weist wie das vierte Ausführungsbeispiel eine konduktive erste Messzelle 7 und eine induktive zweite Messzelle 8 auf. Die Messzellen 7, 8 sind jedoch nicht koaxial ineinander angeordnet, sondern ist die erste Messzelle 7 in Bezug auf den Halteschaft 12 unter der zweiten Messzelle 8 angeordnet.

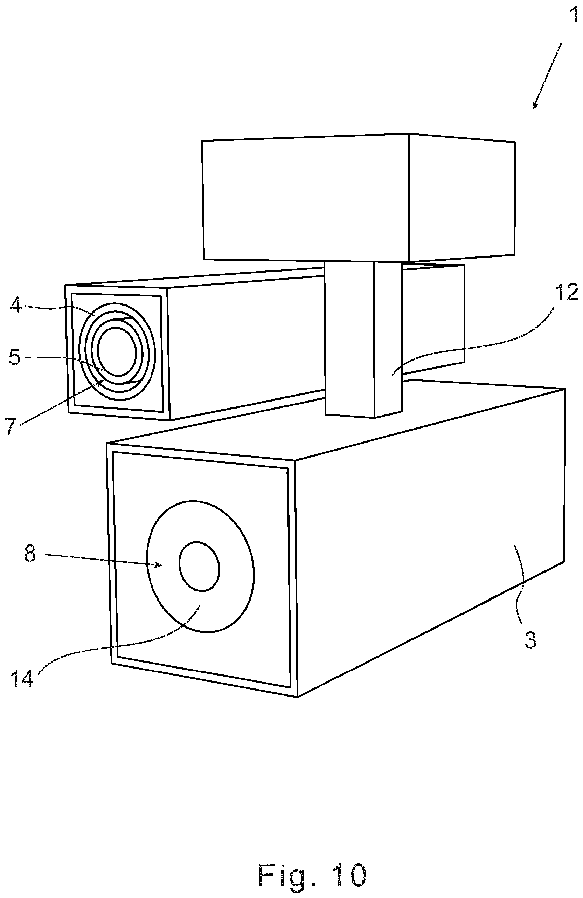

Fig. 10 zeigt ein achtes Ausführungsbeispiel eines Leitfähigkeitsmessgeräts 1 in einer abstrahierten Darstellung. Dieses Ausführungsbeispiel entspricht dem vierten Ausführungsbeispiel abgesehen von den im Folgenden dargestellten Unterschieden, weshalb im Übrigen die Ausführungen zum vierten Ausführungsbeispiel entsprechend für das achte Ausführungsbeispiel gelten.

Das achte Ausführungsbeispiel des Leitfähigkeitsmessgeräts 1 weist wie das vierte Ausführungsbeispiel eine konduktive erste Messzelle 7 und eine induktive zweite Messzelle 8 auf. Die Messzellen 7, 8 sind jedoch nicht koaxial ineinander angeordnet, sondern ist die erste Messzelle 7 an einer Seite des Halteschafts 12 und ist die zweite Messzelle 8 an einem Ende des Halteschafts 12 angeordnet.

### Bezugszeichen

- 1: Leitfähigkeitsmessgerät
- 2: leitfähiges flüssiges Medium
- 3: Gehäuse
- 4: erste Elektrode
- 5: zweite Elektrode
- 6: dritte Elektrode
- 7: erste Messzelle
- 8: zweite Messzelle
- 9: dritte Messzelle
- 10: Steuerungseinrichtung
- 11: Wechselschalter
- 12: Halteschaft
- 13: Trägerplatte
- 14: zylinderförmiger Träger
- 15: Sendespule
- 16: Empfangsspule

## Patentansprüche

1. Leitfähigkeitsmessgerät (1) zur Messung einer elektrischen Leitfähigkeit eines flüssigen Mediums (2) mit einem Gehäuse (3), einer konduktiven ersten Messzelle (7) und einer Steuerungseinrichtung (10) zur Steuerung der ersten Messzelle (7), wobei die erste Messzelle (7) einen ersten Leitfähigkeitsmessbereich und eine erste Elektrode (4) und eine zweite Elektrode (5) aufweist,
**dadurch gekennzeichnet,**
**dass** das Leitfähigkeitsmessgerät (1) eine zweite Messzelle (8) mit einem zweiten Leitfähigkeitsmessbereich aufweist,
**dass** die erste Messzelle (7), die zweite Messzelle (8) und die Steuerungseinrichtung (10) am Gehäuse (3) angeordnet sind,
**dass** die Steuerungseinrichtung (10) zur Steuerung der zweiten Messzelle (8) ausgebildet ist,
**dass** die erste Messzelle (7) und die zweite Messzelle (8) derart ausgebildet sind, dass sich der erste Leitfähigkeitsmessbereich und der zweite Leitfähigkeitsmessbereich überlappen, sodass das Leitfähigkeitsmessgerät einen zusammenhängenden Leitfähigkeitsmessbereich aufweist,
**dass** die Steuerungseinrichtung ausgebildet ist,
- eine elektrische Leitfähigkeit des Mediums, wenn die elektrische Leitfähigkeit sowohl im ersten als auch im zweiten Leitfähigkeitsmessbereich liegt, zum einen mit der ersten Messzelle und zum anderen auch mit der zweiten Messzelle zu bestimmen, sodass die Bestimmung der elektrischen Leitfähigkeit Redundanz aufweist,
eine erste Leitfähigkeit des Mediums (2) mit der ersten Messzelle (7) und eine zweite Leitfähigkeit des Mediums (2) mit der zweiten Messzelle (8) zu bestimmen
- und, wenn die bestimmte erste Leitfähigkeit und/oder die bestimmte zweite Leitfähigkeit in einem Überlappungsleitfähigkeitsmessbereich liegen und die bestimmte erste Leitfähigkeit von der bestimmten zweiten Leitfähigkeit um mehr als einen Leitfähigkeitstoleranzwert voneinander abweichen, einen Fehler zu signalisieren.

2. Leitfähigkeitsmessgerät (1) nach Anspruch 1, **dadurch gekennzeichnet, dass** die zweite Messzelle (8) eine konduktive Messzelle ist.

3. Leitfähigkeitsmessgerät (1) nach Anspruch 2, **dadurch gekennzeichnet, dass** das Leitfähigkeitsmessgerät (1) eine dritte Elektrode (6) aufweist und dass die zweite Elektrode (5) und die dritte Elektrode (6) die zweite Messzelle (8) bilden.

4. Leitfähigkeitsmessgerät (1) nach Anspruch 3, **dadurch gekennzeichnet, dass** die erste Elektrode (4) und die dritte Elektrode (6) eine dritte Messzelle (9) mit einem dritten Leitfähigkeitsmessbereich bilden und dass die Steuerungseinrichtung (10) zur Steuerung der dritten Messzelle (9) ausgebildet ist.

5. Leitfähigkeitsmessgerät (1) nach einem der Ansprüche 1 bis 4, **dadurch gekennzeichnet,**
**dass** mindestens die erste Elektrode (4) und die zweite Elektrode (5) zylinderförmig ausgebildet und koaxial ineinander angeordnet sind oder dass mindestens die erste Elektrode (4) und die zweite Elektrode (5) plattenförmig ausgebildet und parallel zueinander angeordnet sind oder dass das Leitfähigkeitsmessgerät (1) eine Trägerplatte (13) aufweist und mindestens die erste Elektrode (4) und die zweite Elektrode (5) auf der Trägerplatte (13) nebeneinander angeordnet sind.

6. Leitfähigkeitsmessgerät (1) nach Anspruch 1, **dadurch gekennzeichnet, dass** die zweite Messzelle (8) eine induktive Messzelle ist.

7. Leitfähigkeitsmessgerät (1) nach Anspruch 6, **dadurch gekennzeichnet, dass** das Leitfähigkeitsmessgerät (1) einen zylinderförmigen Träger (14) aufweist und die induktive Messzelle (8) um den zylinderförmigen Träger (14) angeordnet ist,
dass die erste Elektrode (4) und die zweite Elektrode (5) der ersten Messzelle (7) zylinderförmig ausgebildet und koaxial ineinander angeordnet sind und dass die erste Messzelle (7) und die zweite Messzelle (8) koaxial ineinander angeordnet sind.

8. Leitfähigkeitsmessgerät (1) nach Anspruch 6, **dadurch gekennzeichnet,**
**dass** die erste Messzelle (7) neben der oder parallel zur zweiten Messzelle (8) angeordnet ist
oder dass die erste Messzelle (7) in Reihe vor oder hinter der zweiten Messzelle (8) angeordnet ist
oder dass die erste Messzelle (7) unter der zweiten Messzelle (8) angeordnet ist
oder dass das Gehäuse (3) einen Halteschaft (12) aufweist und die erste Messzelle (7) in dem oder an dem Halteschaft (12) angeordnet ist.

9. Leitfähigkeitsmessgerät (1) nach einem der Ansprüche 1 bis 8, **dadurch gekennzeichnet, dass** die Steuerungseinrichtung (10) einen Wechselschalter (11) aufweist, dass der Wechselschalter (11) von der Steuerungseinrichtung (10) gesteuert ist und dass der Wechselschalter (11) die Steuerungseinrichtung (10) zumindest mit der ersten Messzelle (7) oder der zweiten Messzelle (8) verbindet.

## Claims

1. Conductivity meter (1) for measuring an electrical conductivity of a liquid medium (2), having a housing (3), a conductive first measuring cell (7) and a control device (10) for controlling the first measuring cell (7), wherein the first measuring cell (7) has a first conductivity measuring range and a first electrode (4) and a second electrode (5)
**characterized in**
**that** the conductivity meter (1) has a second measuring cell (8) with a second conductivity measuring range,
**that** the first measuring cell (7), the second measuring cell (8) and the control device (10) are arranged on the housing (3),
**that** the control device (10) is designed for controlling the second measuring cell (8),
**that** the first measuring cell (7) and the second measuring cell (8) are designed in such a way that the first conductivity measuring range and the second conductivity measuring range overlap, so that the conductivity meter has a continuous conductivity measuring range,
**that** the control device is designed
- to determine an electrical conductivity of the medium, if the electrical conductivity lies both in the first and in the second conductivity measuring range, on the one hand with the first measuring cell and on the other hand also with the second measuring cell, so that the determination of the electrical conductivity has redundancy,
- to determine a first conductivity of the medium (2) with the first measuring cell (7) and a second conductivity of the medium (2) with the second measuring cell (8)
- and, if the determined first conductivity and/or the determined second conductivity lie in an overlap conductivity measuring range and the determined first conductivity differs from the determined second conductivity by more than one conductivity tolerance value, signaling an error.

2. Conductivity meter (1) according to claim 1, **characterized in that** the second measuring cell (8) is a conductive measuring cell.

3. Conductivity meter (1) according to claim 2, **characterized in that** the conductivity meter (1) comprises a third electrode (6) and that the second electrode (5) and the third electrode (6) form the second measuring cell (8).

4. Conductivity meter (1) according to claim 3, **characterized in that** the first electrode (4) and the third electrode (6) form a third measuring cell (9) with a third conductivity measuring range, and that the control device (10) is designed for controlling the third measuring cell (9).

5. Conductivity meter (1) according to any one of claims 1 to 4, **characterized in**
**that** at least the first electrode (4) and the second electrode (5) are designed in the form of a cylinder and are arranged coaxially in one another,
or that at least the first electrode (4) and the second electrode (5) are designed in the shape of a plate and are arranged parallel to each other,
or that the conductivity meter (1) has a carrier plate (13) and at least the first electrode (4) and the second electrode (5) are arranged next to one another on the carrier plate (13).

6. Conductivity meter (1) according to claim 1, **characterized in that** the second measuring cell (8) is an inductive measuring cell.

7. Conductivity meter (1) according to claim 6, **characterized in that** the conductivity meter (1) has a cylindrical support (14) and the inductive measuring cell (8) is arranged around the cylindrical support (14),
that the first electrode (4) and the second electrode (5) of the first measuring cell (7) are designed in a cylindrical shape and are arranged coaxially in one another,
and that the first measuring cell (7) and the second measuring cell (8) are arranged coaxially in one another.

8. Conductivity meter (1) according to claim 6, **characterized in,**
**that** the first measuring cell (7) is arranged next to or parallel to the second measuring cell (8)
or that the first measuring cell (7) is arranged in series in front of or behind the second measuring cell (8)
or that the first measuring cell (7) is arranged below the second measuring cell (8)
or that the housing (3) has a support shaft (12) and the first measuring cell (7) is arranged in or on the support shaft (12).

9. Conductivity meter (1) according to any one of claims 1 to 8, **characterized in that** the control device (10) has a changeover switch (11), that the changeover switch (11) is controlled by the control device (10), and that the changeover switch (11) connects the control device (10) at least to the first measuring cell (7) or the second measuring cell (8).

## Revendications

1. Appareil de mesure de conductivité (1) destiné à mesurer la conductivité électrique d'un milieu liquide (2), ledit appareil comprenant un boîtier (3), une première cellule de mesure conductrice (7) et un dispositif de commande (10) destiné à commander la première cellule de mesure (7), la première cellule de mesure (7) comportant une première zone de mesure de conductivité et une première électrode (4) et une deuxième électrode (5),
**caractérisé en ce que**
l'appareil de mesure de conductivité (1) comporte une deuxième cellule de mesure (8) comportant une deuxième zone de mesure de conductivité,
la première cellule de mesure (7), la deuxième cellule de mesure (8) et le dispositif de commande (10) sont disposés au niveau du boîtier (3),
le dispositif de commande (10) est conçu pour commander la deuxième cellule de mesure (8),
la première cellule de mesure (7) et la deuxième cellule de mesure (8) sont conçues de manière à ce que la première zone de mesure de conductivité et la deuxième zone de mesure de conductivité se chevauchent de sorte que l'appareil de mesure de conductivité comporte une zone de mesure de conductivité continue,
le dispositif de commande est conçu
- pour déterminer une conductivité électrique du milieu, si la conductivité électrique est située aussi bien dans la première que dans la deuxième zone de mesure de conductivité, d'une part avec la première cellule de mesure et d'autre part également avec la deuxième cellule de mesure de sorte que la détermination de la conductivité électrique présente une redondance,
- pour déterminer une première conductivité du milieu (2) avec la première cellule de mesure (7) et une deuxième conductivité du milieu (2) avec la deuxième cellule de mesure (8),
- et pour signaler une erreur, si la première conductivité déterminée et/ou la deuxième conductivité déterminée sont situées dans une zone de mesure de conductivité à chevauchement et si la première conductivité déterminée diffère de la deuxième conductivité déterminée de plus d'une valeur de tolérance de conductivité.

2. Appareil de mesure de conductivité (1) selon la revendication 1, **caractérisé en ce que** la deuxième cellule de mesure (8) est une cellule de mesure conductrice.

3. Appareil de mesure de conductivité (1) selon la revendication 2, **caractérisé en ce que** l'appareil de mesure de conductivité (1) comporte une troisième électrode (6) et **en ce que** la deuxième électrode (5) et la troisième électrode (6) forment la deuxième cellule de mesure (8).

4. Dispositif de mesure de conductivité (1) selon la revendication 3, **caractérisé en ce que** la première électrode (4) et la troisième électrode (6) forment une troisième cellule de mesure (9) comportant une troisième zone de mesure de conductivité et **en ce que** le dispositif de commande (10) est conçu pour commander la troisième cellule de mesure (9).

5. Appareil de mesure de conductivité (1) selon l'une des revendications 1 à 4, **caractérisé en ce que** au moins la première électrode (4) et la deuxième électrode (5) sont de forme cylindrique et sont disposées coaxialement l'une dans l'autre ou au moins la première électrode (4) et la deuxième électrode (5) sont en forme de plaque et sont disposées parallèlement l'une à l'autre
ou l'appareil de mesure de conductivité (1) comporte une plaque de support (13) et au moins la première électrode (4) et la deuxième électrode (5) sont disposées l'une à côté de l'autre sur la plaque de support (13).

6. Appareil de mesure de conductivité (1) selon la revendication 1, **caractérisé en ce que** la deuxième cellule de mesure (8) est une cellule de mesure inductive.

7. Appareil de mesure de conductivité (1) selon la revendication 6, **caractérisé en ce que**
l'appareil de mesure de conductivité (1) comporte un support cylindrique (14) et la cellule de mesure inductive (8) est disposée autour du support cylindrique (14),
la première électrode (4) et la deuxième électrode (5) de la première cellule de mesure (7) sont de forme cylindrique et sont disposées coaxialement l'une dans l'autre
et la première cellule de mesure (7) et la deuxième cellule de mesure (8) sont disposées coaxialement l'une dans l'autre.

8. Appareil de mesure de conductivité (1) selon la revendication 6, **caractérisé en ce que**
la première cellule de mesure (7) est disposée à côté de la deuxième cellule de mesure (8) ou parallèlement à celle-ci,
ou la première cellule de mesure (7) est disposée en série devant ou derrière la deuxième cellule de mesure (8),
ou la première cellule de mesure (7) est disposée sous la deuxième cellule de mesure (8),
ou le boîtier (3) comporte une tige de retenue (12) et la première cellule de mesure (7) est disposée dans la tige de retenue (12) ou contre celle-ci.

9. Appareil de mesure de conductivité (1) selon l'une des revendications 1 à 8, **caractérisé en ce que** le dispositif de commande (10) comporte un commutateur (11),
le commutateur (11) est commandé par le dispositif de commande (10) et
le commutateur (11) relie le dispositif de commande (10) au moins à la première cellule de mesure (7) ou à la deuxième cellule de mesure (8).
